# EUROPÄISCHE PATENTSCHRIFT

(11) **EP 4 090 983 B1**
(45) Veröffentlichungstag und Bekanntmachung des Hinweises auf die Patenterteilung: **08.07.2026**
(21) Anmeldenummer: 21700543.8
(22) Anmeldetag: 12.01.2021
(51) Int. Cl.: G01R 31/14, H02H 5/12

(54) **VERFAHREN UND VORRICHTUNG FÜR EINEN PERSONENSCHUTZ BEI EINER HOCHSPANNUNGSPRÜFUNG**
METHOD AND DEVICE FOR PERSONAL PROTECTION DURING HIGH-VOLTAGE TESTING
PROCÉDÉ ET DISPOSITIF DE PROTECTION PERSONNELLE LORS D'ESSAIS SOUS HAUTE TENSION

(30) Priorität: 15.01.2020 AT 500242020
(43) Veröffentlichungstag der Anmeldung: 23.11.2022
(73) Patentinhaber: Omicron electronics GmbH, 6833 Klaus (AT)
(72) Erfinder: ANGLHUBER, Martin, 6800 Feldkirch (AT)
(74) Vertreter: Kraus & Lederer PartGmbB
(86) Internationale Anmeldenummer: PCT/EP2021/050485
(87) Internationale Veröffentlichungsnummer: WO 2021/144266

(56) Entgegenhaltungen:
- EP-A2- 1 223 730
- CN-A- 108 387 829
- US-A- 3 211 998
- US-A- 4 799 130

## Beschreibung

### GEBIET DER ERFINDUNG

Die vorliegende Erfindung betrifft ein Verfahren für einen Personenschutz bei einer Hochspannungsprüfung an einem Prüfobjekt sowie eine Hochspannungserzeugungsvorrichtung, welche gemäß dem Verfahren für den Personenschutz arbeitet.

### HINTERGRUND DER ERFINDUNG

Hochspannungsisolationsmessungen, beispielsweise Kapazitätsmessungen und Verlustfaktormessungen, sind etablierte Verfahren, um den Zustand von Hochspannungseinrichtungen, wie zum Beispiel Transformatorisolierungen oder Durchführungsisolierungen, zu prüfen. Dabei werden hohe Prüfspannungen, insbesondere hohe Wechselspannungen, von einigen 1000 V, beispielsweise 10 kV verwendet. Ein Messstrom kann dabei einige 100 mA betragen, beispielsweise bis zu 300 mA.

Entsprechende Messgeräte sind üblicherweise derart aufgebaut, dass ein Benutzer vor der hohen Prüfspannung geschützt ist, beispielsweise durch geeignete Isolationen des Messgerätes und der verwendeten Messleitungen. Am Prüfling selbst, beispielsweise an einem Transformator oder einer sonstigen Hochspannungsvorrichtung, können jedoch nicht oder schlecht isolierte Teile vorhanden sein, welche während der Prüfung mit der Hochspannung beaufschlagt werden. Um eine Person vor einer elektrischen Gefährdung während der Messung zu schützen, kann der Prüfbereich beispielsweise abgeschrankt werden und es können Warnsignale ausgegeben werden, beispielsweise optische Warnsignale mit einer roten Leuchte oder einem Blitzlicht, sowie akustische Warnsignale, beispielsweise ein lauter Warnton. Der Personenschutz beruht somit auf der Annahme, dass alle an der Prüfung beteiligten Personen und alle im Prüfbereich befindlichen Personen entsprechende Sicherheitsvorschriften kennen und einhalten. Trotz dieser Sicherheitsvorschriften kommt es immer wieder zu Unfällen, beispielsweise wenn Sicherheitsvorschriften nicht eingehalten oder umgangen werden. Durch die bei der Prüfung verwendete Hochspannung besteht bei Kontakt einer Person mit spannungsführenden Teilen eine erhebliche Lebensgefahr für die Person.

Ein Durchschlagfestigkeitsprüfgerät zum Prüfen von elektrischen Geräten mit hoher Spannung und hoher Stromstärke und mit einem integrierten Personenschutz ist offenbart in US 4799130 A.

### ZUSAMMENFASSUNG DER ERFINDUNG

Im Stand der Technik besteht daher ein Bedarf, den Personenschutz bei Hochspannungsprüfungen oder Hochspannungsmessungen zu verbessern.

Gemäß der vorliegenden Erfindung wird ein Verfahren für einen Personenschutz bei einer Hochspannungsprüfung an einem Prüfobjekt und eine Hochspannungserzeugungsvorrichtung für eine Hochspannungsprüfung an einem Prüfobjekt gemäß den unabhängigen Ansprüchen bereitgestellt. Die abhängigen Ansprüche definieren bevorzugte oder vorteilhafte Ausführungsformen der Erfindung.

Ein Verfahren für einen Personenschutz bei einer Hochspannungsprüfung an einem Prüfobjekt umfasst ein Ausgeben eines Hochspannungswechselstroms für das Prüfobjekt mittels einer Hochspannungserzeugungsvorrichtung. Die Hochspannungserzeugungsvorrichtung weist einen Hochspannungstransformator zur Erzeugung des Hochspannungswechselstroms auf. Der Hochspannungswechselstrom kann beispielsweise zur Durchführung einer Hochspannungs-Isolationsmessung an dem Prüfobjekt verwendet werden. Der Hochspannungswechselstrom kann eine Spannung im Bereich von beispielsweise 2 kV bis 12 kV aufweisen. Weiterhin wird bei dem Verfahren ein zeitlicher Verlauf von mindestens einer elektrischen Größe an dem Hochspannungstransformator während des Ausgebens des Hochspannungswechselstroms bestimmt. Der zeitliche Verlauf der mindestens einen elektrischen Größe kann beispielsweise direkt an dem Hochspannungstransformator gemessen werden oder aus einer oder mehreren Messungen an dem Hochspannungstransformator mittels einer Steuervorrichtung oder Verarbeitungsvorrichtung bestimmt werden. In Abhängigkeit von dem zeitlichen Verlauf der mindestens einen elektrischen Größe wird das Ausgeben des Hochspannungswechselstroms beendet.

Ein zeitlicher Verlauf einer oder mehrerer elektrischer Größen, beispielsweise Strom, Spannung, Leistung, Phasenwinkel oder Impedanz, an einem Prüfobjekt, wie zum Beispiel einem Hochspannungstransformator oder einer Hochspannungsdurchführung, unterscheidet sich von einem entsprechenden zeitlichen Verlauf der einen oder mehreren elektrischen Größen eines stromdurchflossenen menschlichen Körpers, sodass aus einer Beobachtung dieses zeitlichen Verlaufs erkannt werden kann, ob eine Person Kontakt mit dem Hochspannungswechselstrom hat. Wird auf diese Art und Weise ein solcher Kontakt einer Person mit dem Hochspannungswechselstroms erkannt, so kann der Hochspannungswechselstrom abgeschaltet werden, um die Person vor einer Verletzung zu schützen. Dabei ist es von großer Wichtigkeit, dass die Abschaltung so schnell wie möglich erfolgt, da die Länge der Einwirkdauer des Hochspannungswechselstroms auf die Person einen entscheidenden Einfluss auf den Umfang einer möglichen Verletzung haben kann. Beispielsweise treten bei einem Stromfluss von 200 mA und einer Einwirkdauer von weniger als 300 ms im Allgemeinen Muskelkontraktionen mit reversiblen Effekten auf, wohingegen bei längerer Einwirkdauer oder höherem Stromfluss irreversible Effekte möglich sind und zusätzlich die Wahrscheinlichkeit von Herzkammerflimmern erheblich ansteigt.

Beispielsweise kann der Hochspannungstransformator eine Eingangsseite mit einer Eingangswicklung und eine Ausgangsseite mit einer Ausgangswicklung aufweisen. An der Ausgangswicklung wird der Hochspannungswechselstrom für das Prüfobjekt ausgegeben. Der zeitliche Verlauf der mindestens einen elektrischen Größe wird mittels einer Erfassung an der Eingangsseite des Hochspannungstransformators bestimmt. Das Ausgeben des Hochspannungswechselstroms wird in Abhängigkeit von dem so ermittelten zeitlichen Verlauf der mindestens einen elektrischen Größe beendet. An der Eingangswicklung des Hochspannungstransformators liegen üblicherweise deutlich geringere Spannungen als an der Ausgangswicklung des Hochspannungstransformators an. Eine Messung von beispielsweise Strom und Spannung an der Eingangsseite ist aufgrund der geringeren Spannung kostengünstiger und insbesondere schneller durchführbar als an der Ausgangsseite. Die elektrischen Größen an der Eingangswicklung und der Ausgangswicklung des Hochspannungstransformators stehen jedoch in direkter Abhängigkeit zueinander, sodass aus den elektrischen Größen an der Eingangswicklung auf die elektrischen Größen an der Ausgangswicklung geschlossen werden kann. Dadurch ist eine schnelle Erkennung, ob eine Person Kontakt mit dem Hochspannungswechselstrom hat, möglich, sodass eine schnelle Abschaltung erreicht werden kann. Der Zusammenhang zwischen den elektrischen Größen an der Eingangswicklung und den elektrischen Größen an der Ausgangswicklung wird über Eigenschaften des Hochspannungstransformators bestimmt. Daher kann das Abschalten des Hochspannungswechselstroms ferner in Abhängigkeit von mindestens einer Eigenschaft des Hochspannungstransformators erfolgen. Anders ausgedrückt kann bei der Entscheidung, ob der Hochspannungswechselstrom weiterhin ausgegeben wird oder abgeschaltet wird, eine elektrische Größe an der Eingangswicklung erfasst werden und mittels der Eigenschaften des Hochspannungstransformators auf entsprechende elektrische Größen an der Ausgangswicklung geschlossen werden.

Gemäß der Erfindung umfasst die mindestens eine elektrische Größe eine Phasenlage und einen Betrag eines Stroms an dem Hochspannungstransformator sowie eine Phasenlage und einen Betrag einer Spannung an dem Hochspannungstransformator. Bei dem Verfahren kann ferner ein Phasenwinkel zwischen Strom und Spannung an dem Hochspannungstransformator basierend auf den Phasenlagen des Stroms und der Spannung bestimmt werden. Das Ausgeben des Hochspannungswechselstroms wird beendet, wenn der Phasenwinkel kleiner als ein vorgegebener Phasenwinkelschwellenwert ist. Der Phasenwinkelschwellenwert kann im Bereich von beispielsweise 80° bis 89° liegen, vorzugsweise beispielsweise 80° oder 85° betragen. Beispielsweise kann der Hochspannungswechselstrom ausgeschaltet werden, wenn der Phasenwinkel kleiner als 80° ist. Bei einer Isolationsmessung und im Wesentlichen intakter Isolation des Prüflings oder Prüfobjekts stellt der Prüfling im Wesentlichen eine kapazitive Last dar, sodass der Phasenwinkel zwischen Strom und Spannung nahezu 90° beträgt. In diesem Fall eilt der Strom der Spannung nahezu um 90° nach. Wenn eine Person in Kontakt mit dem Hochspannungswechselstroms steht, verkleinert sich der Phasenwinkel, da die Person eine ohmsche Last darstellt. Wenn eine entsprechende Veränderung des Phasenwinkels zwischen Strom und Spannung festgestellt wird, kann der Hochspannungswechselstrom abgeschaltet werden, um die Person zu schützen.

Alternativ oder zusätzlich kann basierend auf den Phasenlagen des Stroms und der Spannung ein Verlustfaktor bestimmt werden. Das ausgeben des Hochspannungswechselstroms wird beendet, wenn der Verlustfaktor größer als ein vorgegebener Verlustfaktorschwellenwert ist. Der Verlustfaktorschwellenwert kann einen Wert im Bereich von beispielsweise 0,5 % bis 10 % aufweisen, vorzugsweise 5 % oder 10 %. Der Verlustfaktor ist gleich dem Tangens des Verlustwinkels, welcher im Falle einer Kapazität 90° minus dem Phasenwinkel entspricht.

Gemäß der Erfindung wird mindestens eine Impedanz einer an den Hochspannungstransformator angeschlossenen Last basierend auf den Beträgen und den Phasenlagen des Stroms und der Spannung bestimmt. Das Ausgeben des Hochspannungswechselstroms wird beendet, wenn die Impedanz kleiner als ein vorgegebener Impedanzschwellenwert ist. Der Impedanzschwellenwert kann im Bereich von beispielsweise 30 kΩ bis 70 kΩ liegen und beträgt vorzugsweise 50 kΩ. Bei Hochspannungsvorrichtungen, bei welchen die Isolation im Wesentlichen in Ordnung ist, beträgt die Impedanz im Allgemeinen deutlich mehr als 50 kΩ, zumeist mehr als 70 kΩ. Kleinere Impedanzen deuten daher entweder auf einen Defekt in der Isolation der Hochspannungsvorrichtung hin, oder darauf, dass eine Person Kontakt zu dem Hochspannungswechselstrom hat. Eine Abschaltung in diesem Fall kann daher die Person vor einem elektrischen Schlag und dessen Folgen wirksam schützen.

Bei einer weiteren Ausführungsform des Verfahrens wird ein zeitlicher Verlauf einer von dem Hochspannungstransformator abgegebenen Leistung bestimmt. Die von dem Hochspannungstransformator abgegebene Leistung wird basierend auf zeitlichen Verläufen der Beträge und der Phasenlagen des Stroms und der Spannung bestimmt. Beispielsweise kann ein Effektivwert der von dem Hochspannungstransformator abgegebenen Leistung bestimmt werden. Wenn sich die abgegebene Leistung innerhalb einer vorgegebenen Zeitdauer um mehr als einen vorgegebenen Leistungsänderungswert ändert, wird das Ausgeben des Hochspannungswechselstroms beendet. Der Leistungsänderungswert kann beispielsweise ein Relativwert sein, beispielsweise im Bereich von 10 % bis 30 %, vorzugsweise beispielsweise 20 %. Die vorgegebene Zeitdauer kann im Bereich von wenigen Millisekunden, beispielsweise 10 ms bis 300 ms liegen, vorzugsweise 200 ms. Anders ausgedrückt wird der Hochspannungswechselstrom abgeschaltet, wenn beispielsweise bestimmt wird, dass sich die von dem Hochspannungstransformator abgegebene Leistung innerhalb von beispielsweise 200 ms um mehr als beispielsweise 20 % erhöht. Unter der Voraussetzung, dass die von dem Hochspannungstransformator abgegebene Spannung in diesem vorgegebenen Zeitraum nicht erhöht wurde, kann diese Erhöhung der abgegebene Leistung darauf hinweisen, dass eine Person ein spannungsführendes Teil berührt hat, sodass ein zusätzlicher Strom durch diese Person fließt und dadurch die abgegebene Leistung erhöht wird. Indem diese Leistungserhöhung in einem verhältnismäßig kurzen Zeitraum von beispielsweise 200 ms erfasst wird, kann der Hochspannungswechselstrom rasch abgeschaltet werden, sodass die Person nur für eine sehr kurze Zeitdauer dem Hochspannungswechselstrom ausgesetzt ist.

Bei einem weiteren Beispiel wird das Ausgeben des Hochspannungswechselstroms beendet, wenn der Betrag des Stroms einen vorgegebenen Stromschwellenwert überschreitet. Der Stromschwellenwert kann im Bereich von 100 mA bis 300 mA liegen und beträgt vorzugsweise 200 mA. Der Strom kann beispielsweise der Effektivwert des Stroms sein. Wie bereits oben beschrieben wurde, tritt bei einer Einwirkung eines Stroms von 200 mA für eine Zeitdauer von 300 ms im Allgemeinen noch keine irreversible Schädigung ein und auch die Wahrscheinlichkeit eines Herzkammerflimmerns ist verhältnismäßig gering.

Das Ausgeben des Hochspannungswechselstroms kann auch dann beendet werden, wenn sich ein zeitlicher Verlauf des Betrags des Stroms innerhalb einer vorgegebenen Zeitdauer um mehr als einen vorgegebenen Stromänderungswert ändert. Die vorgegebene Zeitdauer kann wiederum im Bereich von 10 ms bis 300 ms liegen und vorzugsweise 200 ms betragen. Der Stromänderungswert kann ein relativer Wert sein und beispielsweise 10 % bis 20 % betragen. Bei diesem Beispiel wird der Hochspannungswechselstrom somit abgeschaltet, wenn sich der Strom innerhalb von beispielsweise 200 ms um mehr als 20 % vergrößert. Der Strom kann beispielsweise der Effektivwert des Stroms sein. Wenn eine Person ein spannungsführendes Teil berührt, kann eine derartige plötzliche Erhöhung des Stroms auftreten. Ein Abschalten des Hochspannungswechselstroms in diesem Fall kann daher eine Gefährdung der Person verringern.

Bei einer weiteren Ausführungsform wird das Ausgeben des Hochspannungswechselstroms beendet, wenn beim Ausgeben des Hochspannungswechselstroms für das Prüfobjekt der Betrag der Spannung eine vorgegebene Mindestspannung nicht erreicht. Die Mindestspannung kann im Bereich von beispielsweise 1 kV bis 10 kV liegen. Ursache dafür, dass die vorgegebene Mindestspannung nicht erreicht wird, kann einerseits sein, dass das Prüfobjekt keine hinreichende Isolation aufweist, aber andererseits auch, dass eine Person in Kontakt mit einem spannungsführenden Teil steht und dadurch Strom durch die Person fließt und, aufgrund der begrenzten Leistungsfähigkeit des Hochspannungstransformators, dieser Strom die maximale Ausgangsspannung begrenzt. Ein Abschalten unter diesen Bedingungen kann daher zum Schutz der Person beitragen.

Das Ausgeben des Hochspannungswechselstroms kann ferner beendet werden, wenn sich ein zeitlicher Verlauf des Betrags der Spannung innerhalb einer vorgegebenen Zeitdauer um mehr als einen vorgegebenen Spannungsänderungswert ändert. Der Spannungsänderungswert kann beispielsweise ein Absolutwert sein oder ein Prozentwert zu einem Wert der Spannung zu Beginn der vorgegebenen Zeitdauer. Der Spannungsänderungswert kann beispielsweise im Bereich von -10 % bis -20 % liegen, das heißt, wenn sich die Spannung innerhalb der vorgegebenen Zeitdauer um beispielsweise 10 % oder beispielsweise 20 % ändert, wird der Hochspannungswechselstrom abgeschaltet. Wenn während der Hochspannungsprüfung eine Person ein spannungsführendes Teil berührt, kann der von dem Hochspannungstransformator abzugebende Strom durch den zusätzlichen Stromfluss durch die Person erheblich erhöht werden, sodass, aufgrund der begrenzten Leistungsfähigkeit des Hochspannungstransformators, die Spannung einbricht. Ein Abschalten des Hochspannungswechselstroms aufgrund dieser Situation kann daher eine Gefährdung der Person verringern.

Bei einer weiteren Ausführungsform wird der Hochspannungswechselstrom mit einem kontinuierlich oder in Stufen erhöhten Spannungsbetrag ausgegeben. Beispielsweise kann der Hochspannungswechselstrom beginnend bei einer niedrigen Spannung, beispielsweise in der Größenordnung von 25 V oder 100 V, kontinuierlich oder in Stufen bis zu einer Endspannung erhöht werden. Das Erhöhen des Hochspannungswechselstroms von der niedrigen Spannung, welche beispielsweise auch 1 kV betragen kann, bis zu der Endspannung von beispielsweise 12 kV kann beispielsweise in Stufen von z.B. 1 kV bis 12 KV in einem Zeitraum von wenigen Sekunden, beispielsweise im Bereich von 1 Sekunde bis 5 Sekunden, vorzugsweise innerhalb von 3 Sekunden, erfolgen. In Verbindung mit den zuvor beschriebenen Schutzmechanismen, welche eine Berührung eines spannungsführenden Teils durch eine Person erkennen und dann den Hochspannungswechselstrom abschalten, kann die Gefährdung für die Person weiter verringert werden, da eine Abschaltung bereits durchgeführt werden kann, bevor die volle Messspannung von beispielsweise 12 KV erreicht wird.

Eine Hochspannungserzeugungsvorrichtung für eine Hochspannungsprüfung an einem Prüfobjekt umfasst einen Hochspannungstransformator, einen Ausgang und eine Steuervorrichtung. Die Hochspannungserzeugungsvorrichtung gemäß der Erfindung ist in Anspruch 13 definiert.

Die Hochspannungserzeugungsvorrichtung bzw. das entsprechende Prüfsystem kann vorzugsweise als portable Vorrichtung oder Einheit ausgestaltet sein.

### KURZE BESCHREIBUNG DER FIGUREN

Die vorliegende Erfindung wird nachfolgend unter Bezugnahme auf die beigefügten Figuren im Detail beschrieben werden.
Fig. 1 zeigt schematisch eine Hochspannungserzeugungsvorrichtung gemäß einer Ausführungsform der vorliegenden Erfindung.
Fig. 2 zeigt schematisch einen zeitlichen Verlauf zweier elektrischer Größen an einem Hochspannungstransformator einer Hochspannungserzeugungsvorrichtung gemäß einer Ausführungsform der vorliegenden Erfindung.
Fig. 3 zeigt schematisch einen weiteren zeitlichen Verlauf zweier elektrischer Größen an einem Hochspannungstransformator einer Hochspannungserzeugungsvorrichtung gemäß einer Ausführungsform der vorliegenden Erfindung.
Fig. 4 zeigt ein Ablaufdiagramm mit Schritten eines Verfahrens gemäß einer Ausführungsform der vorliegenden Erfindung.

### DETAILLIERTE BESCHREIBUNG VON AUSFÜHRUNGSBEISPIELEN

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden.

Nachfolgend wird die vorliegende Erfindung anhand von Ausführungsformen unter Bezugnahme auf die Zeichnungen näher erläutert. In den Figuren bezeichnen gleiche Bezugszeichen gleiche oder ähnliche Elemente. Die Figuren sind schematische Repräsentationen verschiedener Ausführungsformen der Erfindung. In den Figuren dargestellte Elemente sind nicht notwendigerweise maßstabsgetreu dargestellt. Die verschiedenen in den Figuren dargestellten Elemente sind derart wiedergegeben, dass ihre Funktion und genereller Zweck dem Fachmann verständlich wird. In den Figuren dargestellte Verbindungen und Kopplungen zwischen funktionellen Einheiten und Elementen können auch als indirekte Verbindung oder Kopplung implementiert werden. Funktionale Einheiten können als Hardware, Software oder eine Kombination aus Hardware und Software implementiert werden.

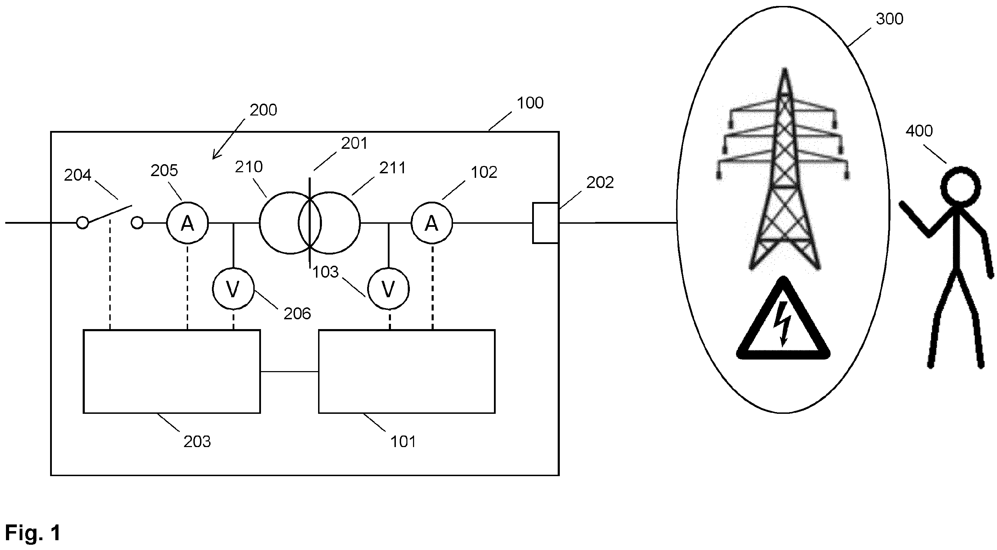

Fig. 1 zeigt ein Hochspannungs-Wechselspannungsprüfgerät 100 in Verbindung mit einem Prüfobjekt oder Messobjekt 300 sowie eine Person 400. Das Prüfobjekt 300, welches auch als Prüfling bezeichnet wird, umfasst eine Hochspannungsvorrichtung, wie zum Beispiel einen Transformator, einen Hochspannungsschalter oder eine Hochspannungsdurchführung. Das Hochspannungs-Wechselspannungsprüfgerät 100 ist eingerichtet, eine Hochspannungs-Isolationsmessung an dem Prüfobjekt 300 durchzuführen. Dazu wird das Prüfobjekt 300 mit einer Prüfspannung im Bereich von einigen 1000 V, beispielsweise 2 kV bis 12 kV, beaufschlagt und ein sich ergebender Strom durch das Prüfobjekt 300 ermittelt. Eine Qualität einer Isolation des Prüfobjekts 300 gegenüber Masse oder einem anderen Leiter kann anhand von Strom und Spannung ermittelt werden. Dazu weist das Hochspannungs-Wechselspannungsprüfgerät 100 beispielsweise eine Strommessvorrichtung 102 sowie eine Spannungsmessvorrichtung 103 auf, welche einen in das Prüfobjekt 300 eingespeisten Strom beziehungsweise eine an dem Prüfobjekt 300 anliegende Spannung messen. Um eine qualitativ hochwertige Aussage bezüglich der Isolation des Prüfobjekts zu erlangen, weisen die Messvorrichtungen 102,103 eine hohe Genauigkeit auf und erfassen elektrische Signale, welche direkt in Verbindung mit dem Prüfobjekt 300 stehen, beispielsweise Strom und Spannung. Strom und Spannung können dazu beispielsweise abgetastet werden, beispielsweise mit einer Abtastrate welche deutlich über der Frequenz des in das Prüfobjekt 300 eingespeisten Hochspannungswechselstroms ist. In einer Verarbeitungsvorrichtung 101 des Hochspannungs-Wechselspannungsprüfgeräts 100 werden die abgetasteten Strom- und Spannungssignale verarbeitet und beispielsweise ein Isolationswiderstand bestimmt und an einen Benutzer ausgegeben.

Das Hochspannungs-Wechselspannungsprüfgerät 100 umfasst ferner eine Hochspannungserzeugungsvorrichtung 200 zur Erzeugung des in das Prüfobjekt 300 einzuspeisenden Hochspannungswechselstroms. Die Hochspannungserzeugungsvorrichtung 200 umfasst einen Hochspannungstransformator 201, welcher an einer Ausgangsseite 211 mit seiner Ausgangswicklung über einen Ausgang 202 mit dem Prüfobjekt 300 koppelbar ist. An einer Eingangsseite 210 ist eine Eingangswicklung des Hochspannungstransformators 201 über eine Schaltvorrichtung 204 mit einer Energieversorgung, beispielsweise mit einem Energieversorgungsnetz mit einer Spannung im Bereich von 110 bis 240 V Wechselspannung verbunden. Der Hochspannungstransformator 201 ist derart ausgestaltet, dass er auf der Grundlage der ihm an der Eingangswicklung zugeführten Spannung an der Ausgangswicklung den gewünschten Hochspannungswechselstrom für die Messung bereitstellt. Die Hochspannungserzeugungsvorrichtung 200 umfasst weiterhin eine Steuervorrichtung 203 sowie Messvorrichtungen 205, 206, beispielsweise eine Strommessvorrichtung 205 und eine Spannungsmessvorrichtung 206. Die Messvorrichtungen 205, 206 sind verglichen mit den Messvorrichtungen 102 und 103 weniger auf hohe Präzision ausgelegt, sondern vielmehr für eine schnelle Messung. Die Messvorrichtungen 205, 206 können ebenso wie die Messvorrichtungen 102, 103 Stromwerte beziehungsweise Spannungswerte abtasten und die Abtastwerte der Steuervorrichtung 203 zur Verfügung stellen. Eine Abtastrate der Messvorrichtungen 102, 103 kann erheblich höher als die Frequenz der Spannung an der Eingangswicklung des Hochspannungstransformators 201 sein, beispielsweise um einen Faktor 10 bis 100 höher, also beispielsweise eine Abtastrate von 500 bis 5000 Abtastwerten pro Sekunde bei einer Frequenz von 50 Hz der Spannung an der Eingangswicklung. Die Steuervorrichtung 203 ist mit der Schaltvorrichtung 204 gekoppelt und in der Lage, die Stromversorgung für den Hochspannungstransformator 201 ein- beziehungsweise auszuschalten. Die Hochspannungserzeugungsvorrichtung 200 kann weitere Komponenten umfassen, um beispielsweise einen Hochspannungswechselstrom mit einstellbarer Spannung unter der Steuerung der Steuervorrichtung 203 bereitzustellen, beispielsweise um den Hochspannungswechselstrom kontinuierlich oder in Stufen von beispielsweise 1 kV bis auf 12 kV erhöhen zu können.

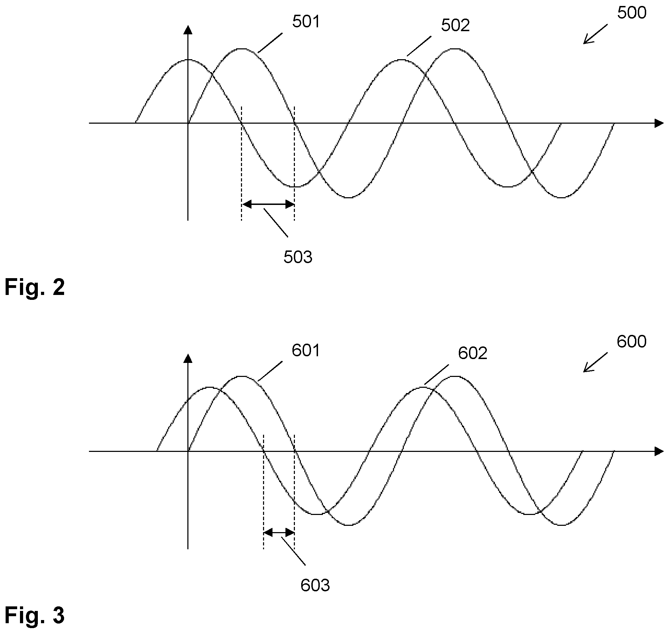

Fig. 2 zeigt ein Diagramm 500 mit einem zeitlichen Verlauf einer Spannung 501 und einem zeitlichen Verlauf eines Stroms 502, wie sie beispielsweise an dem Hochspannungstransformator 201 bei einer Isolationsmessung des Prüfobjekts 300 mit einer im Wesentlichen kapazitiven Last auftreten. Bei einer im Wesentlichen kapazitiven Last besteht ein Phasenwinkel 503 von näherungsweise 90° zwischen dem zeitlichen Verlauf der Spannung 501 und dem nacheilenden zeitlichen Verlauf des Stroms 502. Bei einer typischen Isolationsmessung einer Hochspannungseinrichtung, wie zum Beispiel eines Hochspannungstransformators oder einer Hochspannungsdurchführung, liegt beispielsweise eine Kapazität im Bereich von bis zu 50 Nanofarad vor, sodass bei 12 kV ein maximaler Strom von näherungsweise 150 mA fließt. Dies entspricht einer Impedanz von ungefähr 60 kΩ bis 70 kΩ. Ein Verlustfaktor ist typischerweise kleiner 10 %, das heißt, der Verlustwinkel ist kleiner als 6° und somit der Phasenwinkel zwischen Strom und Spannung größer als 84°. Verlustfaktor, Verlustwinkel und Phasenwinkel stehen in direkter Beziehung zueinander. Der Verlustfaktor ist der Tangens des Verlustwinkels und der Verlustwinkel beträgt bei kapazitiver Last 90° minus dem Phasenwinkel. Nachfolgend wird im Wesentlichen der Verlustfaktor betrachtet werden. Es ist jedoch klar, dass die gleichen Betrachtungen für den Phasenwinkel und den Verlustwinkel gelten.

Wenn die Person 400 in Kontakt mit einem spannungsführenden Teil des Prüfobjekts 300 kommt, kann ein zusätzlicher Strom durch die Person 400 fließen. Da der menschliche Körper einen im Wesentlichen ohmschen Widerstand aufweist, ändern sich Phasenwinkel, Verlustwinkel und Verlustfaktor. Die Impedanz des menschlichen Körpers ist unter anderem von der angelegten Spannung, der Kontaktfläche und der Lage der Kontaktpunkte, an denen die Spannung anliegt, abhängig. Mit steigender Spannung sinkt die Impedanz und kann bei Spannungen von beispielsweise 1000 V einen Betrag im Bereich von 700 Ω bis 1500 Ω aufweisen. Fig. 3 zeigt ein Diagramm 600 mit einem zeitlichen Verlauf einer Spannung 601 und einen zeitlichen Verlauf eines Stroms 602, wie sie beispielsweise an dem Hochspannungstransformator 201 bei einer Isolationsmessung des Prüfobjekts 300 und gleichzeitigem Kontakt zu der Person 400 auftreten. Ein Phasenwinkel 603 zwischen dem zeitlichen Verlauf der Spannung 601 und dem nacheilenden zeitlichen Verlauf des Stroms 602 ist kleiner als der Phasenwinkel 503 in der Fig. 2 ohne den Kontakt zu der Person 400. Der Verlustfaktor steigt dadurch an und beträgt typischerweise mindestens 10 %.

Zusätzlich (in der Fig. 3 jedoch nicht gezeigt) kann der Betrag des Stroms 602 durch die insgesamt geringere Impedanz ansteigen. Dadurch kann auch die gesamte von dem Hochspannungstransformator 201 an der Ausgangswicklung abgegebene und somit an der Eingangswicklung aufgenommene Leistung ansteigen. Weiterhin kann, da der Hochspannungstransformator 201 selbst einen bestimmten Innenwiderstand aufweist, die Spannung 601 durch die geringere Impedanz sinken.

Die zuvor genannten Erkenntnisse können genutzt werden, um einen Personenschutz bei Hochspannungsprüfungen oder Hochspannungsmessungen, insbesondere Hochspannungs-Isolationsmessungen, zu verbessern. Bei Hochspannungsprüfungen, insbesondere Hochspannungs-Isolationsmessungen, wird das Prüfobjekt mit einer hohen Spannung von einigen 1000 V beaufschlagt. Das Messgerät, welches diese hohe Messspannung erzeugt, ist im Allgemeinen so ausgestaltet, dass eine Berührung von spannungsführenden Teilen ausgeschlossen ist. An dem Prüfobjekt, beispielsweise Transformatoren oder Hochspannungsdurchführungen, kann die Spannung jedoch auch an exponierten Teilen anliegen, welche während der Messung von einer Person berührt werden können. Um dies zu vermeiden, werden üblicherweise Sicherheitsmaßnahmen getroffen, um eine Berührung mit spannungsführenden Teilen auszuschließen. Diese Sicherheitsmaßnahmen umfassen beispielsweise ein Abschranken des Messbereichs oder optische und/oder akustische Warnhinweise. Trotz dieser Sicherheitsmaßnahmen können Unfälle auftreten, wenn beispielsweise Sicherheitsvorschriften nicht eingehalten oder umgangen werden. Wenn eine Person in Kontakt mit einer hohen Spannung kommt, ist die Einwirkdauer dieser hohen Spannung von entscheidender Bedeutung für den Verletzungsgrad. Daher ist es wichtig, eine Berührung eines spannungsführenden Teils durch die Person so schnell wie möglich zu erkennen und die Spannung in diesem Fall so schnell wie möglich abzuschalten.

Durch Auswertung von Strom und Spannung nach Betrag und Phase am Hochspannungstransformator 201 kann die Steuervorrichtung 203 ermitteln, ob die gesamte Last kapazitiv dominiert ist, beispielsweise wenn der Verlustfaktor kleiner als 10 % ist, und sich die Impedanz der Last in einem Bereich bewegt, welcher für ein Prüfobjekt typisch ist und für einen stromdurchflossenen Körper untypisch ist, beispielsweise bei einer Impedanz von >50 kΩ. In diesem Fall wird die Messung fortgesetzt. Falls jedoch der Verlustfaktor größer als beispielsweise 10 % ist oder die Impedanz in einen Bereich fällt, welcher durch eine stromdurchflossene Person hervorgerufen werden kann, zum Beispiel bei einer Impedanz von weniger als 50 kΩ, wird die Messung sofort unterbrochen. Dazu kann die Steuervorrichtung 203 die Schaltvorrichtung 204 öffnen, sodass der Hochspannungstransformator 201 keinen Hochspannungswechselstrom am Ausgang 202 bereitstellt. Weiterhin kann der Hochspannungswechselstrom abgeschaltet werden, wenn sich die vom Hochspannungstransformator aufgenommene oder abgegebene Leistung plötzlich ändert, ein Strom plötzlich ansteigt oder die Spannung plötzlich einbricht. Die Detektion und Abschaltung sollte innerhalb sehr kurzer Zeit nach dem Beginn der Durchströmung der Person erfolgen, vorzugsweise in weniger als 300 ms, um dauerhafte Schäden zu vermeiden. Demzufolge ist in einer bevorzugten Ausführungsform die Erfindung derart ausgestaltet, dass das Verfahren einschließlich der Detektion und Abschaltung innerhalb von 300 ms erfolgt. Eine Messung von elektrischen Größen, insbesondere ein zeitlicher Verlauf dieser elektrischen Größen, auf der Ausgangsseite 211 des Hochspannungstransformators 201, also auf der Hochspannungsseite des Hochspannungstransformators 201, steht in vielen Fällen nicht schnell genug zur Verfügung, da diese Messungen in der Regel auf Präzision und nicht auf Schnelligkeit ausgelegt sind. Daher werden entsprechende Größen vorzugsweise auf der Eingangsseite 210 des Hochspannungstransformators 201, also auf der Primärseite oder Niederspannungsseite des Hochspannungstransformators 201, gemessen und unter Berücksichtigung von Eigenschaften des Hochspannungstransformators 201, wie zum Beispiel internen Verlusten, die entsprechenden Werte auf der Ausgangsseite 211 des Hochspannungstransformators 201 abgeschätzt, um so eine deutlich schnellere Messung zu erreichen. Die Abschaltung erfolgt, sobald angenommen wird, dass sich ein stromdurchflossenen Körper im Stromkreis befindet. Dies kann vollautomatisiert und somit sehr schnell durchgeführt werden, sodass in der Regel ein größerer Personenschaden vermieden werden kann. Eine korrekt ablaufende Messung, also eine Messung bei der keine Person Kontakt zu spannungsführenden Teilen hat, wird dadurch nicht beeinträchtigt.

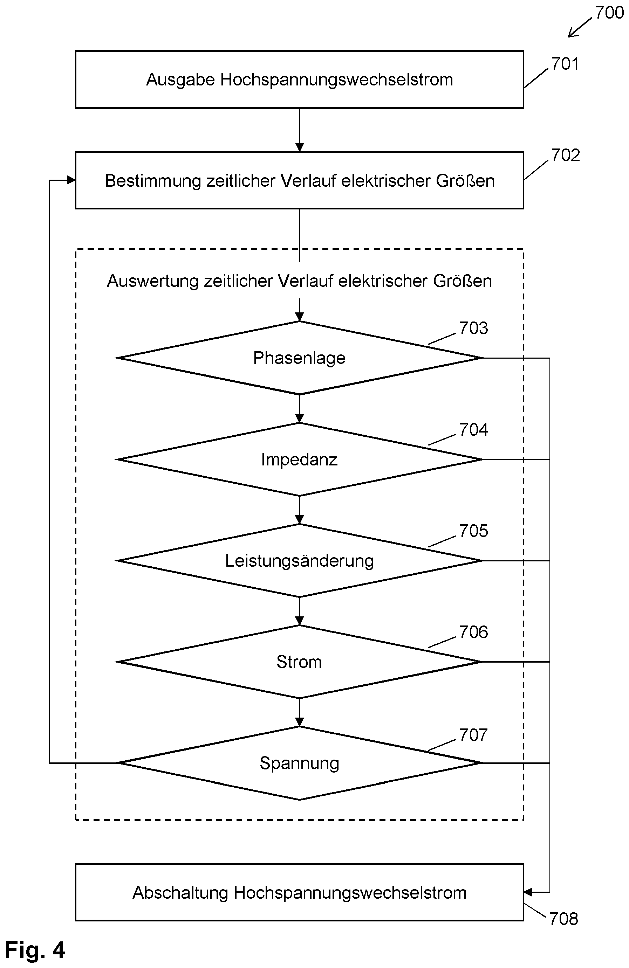

Fig. 4 zeigt Details eines entsprechenden Verfahrens, welches beispielsweise in der Steuervorrichtung 203 durchgeführt werden kann. Die Steuervorrichtung 203 kann dazu eine elektronische Steuerung, wie zum Beispiel einen Prozessor, insbesondere einen Signalprozessor umfassen. Die elektronische Steuerung kann aber auch in analoger Bauweise realisiert werden. Das in Fig. 4 gezeigte Verfahren 700 umfasst Verfahrensschritte 701 bis 708. Obwohl die Verfahrensschritte in einer bestimmten Reihenfolge in der Fig. 4 gezeigt sind, können die Verfahrensschritte in einer beliebigen anderen Reihenfolge oder parallel ausgeführt werden. Insbesondere die Verfahrensschritte 703 bis 707 können in einer beliebigen anderen Reihenfolge oder vorzugsweise zeitlich parallel durchgeführt werden.

Zu Beginn der Hochspannungsprüfung wird im Schritt 701 ein Hochspannungswechselstrom in dem Hochspannungs-Wechselspannungsprüfgerät 100 erzeugt und ausgegeben. Dazu wird die Schaltvorrichtung 204 eingeschaltet, sodass der Hochspannungstransformator 201 mit elektrischer Energie versorgt wird. Der Hochspannungstransformator 201 erzeugt aus der ihm zugeführten elektrischen Energie als Prüfspannung einen Hochspannungswechselstrom, welcher an dem Ausgang 202 ausgegeben wird. Am Ausgang 202 ist das Prüfobjekt 300 angeschlossen. Die Hochspannungsprüfung kann beispielsweise eine Hochspannungs-Isolationsmessung sein, bei welcher eine Isolation des Prüfobjekts 300 überprüft wird. Dazu werden während der Ausgabe des Hochspannungswechselstroms an das Prüfobjekt 300 Strom und Spannung des Hochspannungswechselstroms mithilfe der Messvorrichtungen 102 und 103 ermittelt. Um genaue Messergebnisse der Hochspannungs-Isolationsmessung zu erreichen, sind die Strommessvorrichtung 102 und die Spannungsmessvorrichtung 103 üblicherweise für eine sehr genaue, allerdings nicht für eine sehr schnelle Messung ausgelegt. Insbesondere die Spannungsmessvorrichtung 103 muss derart ausgestaltet sein, dass sie sehr hohe Spannungen von einigen 1000 V messen kann. Spannungsmessungen bei derartig hohen Spannungen erfordern üblicherweise mehr Zeit als Spannungsmessungen bei niedrigeren Spannungen, beispielsweise bei Spannungen unter 500 V.

Das Hochspannungs-Wechselspannungsprüfgerät 100 weist auch auf der Eingangsseite 210 des Transformators 201 Messvorrichtungen auf, beispielsweise die Strommessvorrichtung 205 und die Spannungsmessvorrichtung 206. Die Messvorrichtungen 205 und 206 können eine geringere Genauigkeit als die Messvorrichtungen 102 und 103 haben, sind dafür aber in der Lage, die Messungen wesentlich schneller durchzuführen. Beispielsweise können die Messvorrichtungen 205 und 206 aktuelle Strom- und Spannungswerte mit einer Abtastrate im Bereich von 500 bis 5000 Abtastwerten pro Sekunde und einer Verzögerung von nur wenigen Millisekunden, beispielsweise weniger als 100 ms, bereitstellen. Die Abtastrate ist deutlich höher als die Frequenz des Hochspannungswechselstroms, beispielsweise um einen Faktor von 10 bis 100. Dadurch kann auf der Grundlage der Abtastwerte im Schritt 702 ein zeitlicher Verlauf der elektrischen Größen, beispielsweise ein zeitlicher Verlauf des Stroms und der Spannung an der Eingangsseite 210 des Hochspannungstransformators 201 bestimmt werden. Unter Berücksichtigung von Eigenschaften des Hochspannungstransformators 201, wie zum Beispiel Windungsverhältnis der Eingangswicklung zu der Ausgangswicklung, internen Verlusten und Übertragungseigenschaften, kann auf entsprechende Verläufe von elektrischen Größen an dem Ausgang 202 geschlossen werden.

In den Schritten 703 bis 707 erfolgt nun eine Auswertung der zeitlichen Verläufe dieser elektrischen Größen. Dabei können entweder die zeitlichen Verläufe der elektrischen Größen an der Eingangsseite 210 des Hochspannungstransformators 201 direkt verwendet werden oder die daraus abgeschätzten zeitlichen Verläufe der entsprechenden elektrischen Größen an der Ausgangsseite 211 des Hochspannungstransformators 201 verwendet werden. In den Schritten 703 bis 707 verwendete Schwellenwerte müssen entsprechend angepasst sein.

Im Schritt 703 wird die Phasenlage von Strom und Spannung ausgewertet. Auf der Grundlage der Phasenlage von Strom zu Spannung kann beispielsweise ein Verlustfaktor bestimmt werden und der Hochspannungswechselstrom im Schritt 708 abgeschaltet werden, wenn der Verlustfaktor über einen vorgegebenen Schwellenwert steigt, beispielsweise über 10 %. Zum Abschalten des Hochspannungswechselstroms im Schritt 708 kann die Steuervorrichtung 703 die Schaltvorrichtung 204 entsprechend ansteuern.

Im Schritt 704 wird eine Impedanz ermittelt, wie sie sich am Ausgang 202 aus Sicht des Hochspannungs-Wechselspannungsprüfgeräts 100 ergibt. Die Impedanz wird durch das Prüfobjekt 300 und gegebenenfalls durch die Person 400 bestimmt. Wenn die Impedanz einen vorbestimmten Schwellenwert unterschreitet, beispielsweise unter 50 kΩ sinkt, kann die Steuervorrichtung 203 im Schritt 708 den Hochspannungswechselstrom durch Ansteuern der Schaltvorrichtung 204 abschalten.

Weiterhin kann im Schritt 705 eine an dem Ausgang 202 abgegebene Leistung abgeschätzt werden und über der Zeit beobachtet werden. Die Leistung kann beispielsweise die Scheinleistung oder die Wirkleistung sein. Bei einer plötzlichen Leistungsänderung kann die Steuervorrichtung 203 im Schritt 708 den Hochspannungswechselstrom abschalten. Eine plötzliche Leistungsänderung kann beispielsweise über eine relative Leistungsänderung innerhalb einer vorgegebenen Zeitdauer definiert werden. Beispielsweise kann als plötzliche Leistungsänderung angesehen werden, wenn die abgegebene Leistung innerhalb von 200 ms um einen Prozentsatz von mehr als 10 % oder 20 % ansteigt. Dieser plötzliche Anstieg kann dadurch hervorgerufen werden, dass die Person 400 ein spannungsführendes Teil berührt. Alternativ kann statt der an dem Ausgang 202 abgegebenen Leistung auch die von dem Hochspannungstransformator 201 aufgenommene Leistung ermittelt werden und gegebenenfalls unter Berücksichtigung von internen Verlusten des Hochspannungstransformators 201 auf gleiche Art und Weise als Kriterium für die Abschaltung des Hochspannungswechselstroms verwendet werden.

In vergleichbarer Art und Weise kann im Schritt 706 ein an dem Ausgang 202 abgegebener Strom abgeschätzt werden und über der Zeit beobachtet werden. Der Strom kann beispielsweise ein Effektivstrom sein. Bei einem plötzlichen Stromanstieg kann die Steuervorrichtung 203 im Schritt 708 den Hochspannungswechselstrom abschalten. Die plötzliche Stromänderung kann beispielsweise über eine relative Stromänderung innerhalb einer vorgegebenen Zeitdauer definiert werden. Wenn der Strom zum Beispiel innerhalb einer Zeitdauer von 100 oder 200 ms um mehr als 10 % oder 20 % ansteigt, kann dies als eine plötzliche Stromänderung angesehen werden. Der plötzliche Anstieg des Stroms kann durch einen Kontakt der Person 400 mit einem spannungsführenden Teil hervorgerufen werden.

Gleichermaßen kann im Schritt 707 eine an dem Ausgang 202 anliegende Spannung abgeschätzt werden und über der Zeit beobachtet werden. Die Spannung kann beispielsweise eine Effektivspannung sein. Bei einem plötzlichen Spannungsabfall kann die Steuervorrichtung 203 im Schritt 708 den Hochspannungswechselstrom abschalten. Der plötzliche Spannungsabfall kann dadurch entstehen, dass die Person 400 ein spannungsführendes Teil berührt. Durch die verhältnismäßig geringe Impedanz der Person 400, verglichen mit der Impedanz der Isolation des Prüfobjekts 300, kann der Strom so stark steigen, dass der Hochspannungstransformator 201 aufgrund seines Innenwiderstands oder einer entsprechenden Schutzbeschaltung des Hochspannungstransformators 201 die Ausgangsspannung nicht aufrechterhalten kann. Ebenso kann die Steuervorrichtung 203 den Hochspannungswechselstrom abschalten, wenn eine gewünschte Ausgangsspannung beim Einschalten des Hochspannungswechselstroms nicht erreicht wird. Führen die Auswertungen der zeitlichen Verläufe der elektrischen Größen in den Schritten 703 bis 707 nicht zu der Abschaltung des Hochspannungswechselstroms im Schritt 708, so wird das Verfahren 700 mit dem Schritt 702 fortgesetzt, bis die Hochspannungs-Wechselstrommessung beendet ist. Mit dem zuvor beschriebenen Verfahren 700 kann daher ein Personenschutz bei einer Hochspannungswechselstrommessung verbessert werden.

Selbstverständlich können die Merkmale der vorab beschriebenen Ausführungsformen und Aspekte der Erfindung miteinander kombiniert werden. Insbesondere können die Merkmale nicht nur in den beschriebenen Kombinationen, sondern, soweit innerhalb des Gegenstands der Ansprüche, auch in anderen Kombinationen oder für sich genommen verwendet werden, ohne das Gebiet der Erfindung zu verlassen.

## Patentansprüche

1. Verfahren für einen Personenschutz bei einer Hochspannungsprüfung an einem Prüfobjekt, umfassend:
- Ausgeben (701) eines Hochspannungswechselstroms für das Prüfobjekt (300) mittels einer Hochspannungserzeugungsvorrichtung (200), welche einen Hochspannungstransformator (201) zur Erzeugung des Hochspannungswechselstroms aufweist,
- Bestimmen (702) eines zeitlichen Verlaufs von mindestens einer elektrischen Größe an dem Hochspannungstransformator (201) während des Ausgebens des Hochspannungswechselstroms, wobei die mindestens eine elektrische Größe eine Phasenlage und einen Betrag eines Stroms (502, 602) an dem Hochspannungstransformator (201) und eine Phasenlage und einen Betrag einer Spannung (501, 601) an dem Hochspannungstransformator (201) umfasst,
- Bestimmen einer Impedanz basierend auf den Beträgen und den Phasenlagen des Stroms (502, 602) und der Spannung (501, 601), und
- Beenden (708) des Ausgebens des Hochspannungswechselstroms in Abhängigkeit von dem zeitlichen Verlauf der mindestens einen elektrischen Größe, wobei das Ausgeben des Hochspannungswechselstroms beendet wird, wenn die Impedanz kleiner als ein vorgegebener Impedanzschwellenwert ist.

2. Verfahren nach Anspruch 1,
wobei der Hochspannungstransformator (201) eine Eingangsseite (210) und eine Ausgangsseite (211), an welcher der Hochspannungswechselstrom für das Prüfobjekt (300) ausgegeben wird, umfasst,
wobei der zeitliche Verlauf der mindestens einen elektrischen Größe mittels Erfassung an der Eingangsseite (210) des Hochspannungstransformators (201) bestimmt wird, und
wobei das Ausgeben des Hochspannungswechselstroms ferner in Abhängigkeit von mindestens einer Eigenschaft des Hochspannungstransformators (201) beendet wird.

3. Verfahren nach Anspruch 1 oder Anspruch 2, wobei das Verfahren ferner umfasst:
- Bestimmen eines Phasenwinkels (503, 603) zwischen Strom (502, 602) und Spannung (501, 601) an dem Hochspannungstransformator (201) basierend auf den Phasenlagen des Stroms (502, 602) und der Spannung (501, 601), wobei das Ausgeben des Hochspannungswechselstroms beendet wird, wenn der Phasenwinkel (503, 603) kleiner als ein vorgegebener Phasenwinkelschwellenwert ist.

4. Verfahren nach einem der vorhergehenden Ansprüche, wobei das Verfahren ferner umfasst:
- Bestimmen eines Verlustfaktors basierend auf den Phasenlagen des Stroms (502, 602) und der Spannung (501, 601), wobei das Ausgeben des Hochspannungswechselstroms beendet wird, wenn der Verlustfaktor größer als ein vorgegebener Verlustfaktorschwellenwert ist.

5. Verfahren nach einem der vorhergehenden Ansprüche, wobei das Verfahren ferner umfasst:
- Bestimmen eines zeitlichen Verlaufs einer von dem Hochspannungstransformator (201) abgegebenen Leistung basierend auf zeitlichen Verläufen der Beträge und der Phasenlagen des Stroms (502, 602) und der Spannung (501, 601), wobei das Ausgeben des Hochspannungswechselstroms beendet wird, wenn sich die abgegebene Leistung innerhalb einer vorgegebenen Zeitdauer um mehr als einen vorgegebenen Leistungsänderungswert ändert.

6. Verfahren nach einem der vorhergehenden Ansprüche, wobei die mindestens eine elektrische Größe einen Betrag eines Stroms (502, 602) an dem Hochspannungstransformator (201) umfasst.

7. Verfahren nach Anspruch 6, wobei das Ausgeben des Hochspannungswechselstroms beendet wird, wenn der Betrag des Stroms (502, 602) einen vorgegebenen Stromschwellenwert überschreitet.

8. Verfahren nach Anspruch 6 oder Anspruch 7, wobei das Ausgeben des Hochspannungswechselstroms beendet wird, wenn sich ein zeitlicher Verlauf des Betrags des Stroms (502, 602) innerhalb einer vorgegebenen Zeitdauer um mehr als einen vorgegebenen Stromänderungswert ändert.

9. Verfahren nach einem der vorhergehenden Ansprüche, wobei die mindestens eine elektrische Größe einen Betrag einer Spannung (501, 601) an dem Hochspannungstransformator (201) umfasst.

10. Verfahren nach Anspruch 9, wobei das Ausgeben des Hochspannungswechselstroms beendet wird, wenn beim Ausgeben des Hochspannungswechselstroms für das Prüfobjekt (300) der Betrag der Spannung (501, 601) eine vorgegebene Mindestspannung nicht erreicht.

11. Verfahren nach Anspruch 9 oder Anspruch 10, wobei das Ausgeben des Hochspannungswechselstroms beendet wird, wenn sich ein zeitlicher Verlauf des Betrags der Spannung (501, 601) innerhalb einer vorgegebenen Zeitdauer um mehr als einen vorgegebenen Spannungsänderungswert ändert.

12. Verfahren nach einem der vorhergehenden Ansprüche, wobei das Ausgeben (701) des Hochspannungswechselstroms ein Ausgeben eines Hochspannungswechselstroms mit einem kontinuierlich oder in Stufen erhöhten Spannungsbetrag umfasst.

13. Hochspannungserzeugungsvorrichtung für eine Hochspannungsprüfung an einem Prüfobjekt, umfassend:
- einen Hochspannungstransformator (201) zur Erzeugung eines Hochspannungswechselstroms,
- einen Ausgang (202) zum Ausgeben des Hochspannungswechselstroms für das Prüfobjekt (300), und
- eine Steuervorrichtung (203), welche ausgestaltet ist, eine Person (400) bei der Hochspannungsprüfung zu schützen durch:
- Ausgeben (701) des Hochspannungswechselstroms für das Prüfobjekt (300),
- Bestimmen (702) eines zeitlichen Verlaufs mindestens einer elektrischen Größe an dem Hochspannungstransformator (201) während des Ausgebens des Hochspannungswechselstroms, wobei die mindestens eine elektrische Größe eine Phasenlage und einen Betrag eines Stroms (502, 602) an dem Hochspannungstransformator (201) und eine Phasenlage und einen Betrag einer Spannung (501, 601) an dem Hochspannungstransformator (201) umfasst,
- Bestimmen einer Impedanz basierend auf den Beträgen und den Phasenlagen des Stroms (502, 602) und der Spannung (501, 601), und
- Beenden (708) des Ausgebens des Hochspannungswechselstroms in Abhängigkeit von dem zeitlichen Verlauf der mindestens einen elektrischen Größe, wobei das Ausgeben des Hochspannungswechselstroms beendet wird, wenn die Impedanz kleiner als ein vorgegebener Impedanzschwellenwert ist.

14. Hochspannungserzeugungsvorrichtung nach Anspruch 13, wobei die Hochspannungserzeugungsvorrichtung (200) ausgestaltet ist, das Verfahren (700) nach einem der Ansprüche 1-12 auszuführen.

15. Hochspannungserzeugungsvorrichtung nach Anspruch 13 oder Anspruch 14, wobei die Hochspannungsvorrichtung als eine portable Vorrichtung ausgestaltet ist.

## Claims

1. A method for personal protection during a high-voltage test on a test object, comprising:
- outputting (701) a high-voltage AC current for the test object (300) by means of a high-voltage generating device (200) that has a high-voltage transformer (201) for generating the high-voltage AC current,
- determining (702) a temporal profile of at least one electrical variable at the high-voltage transformer (201) while the high-voltage AC current is being output, wherein the at least one electrical variable comprises a phase position and an absolute value of a current (502, 602) on the high-voltage transformer (201) and a phase position and an absolute value of a voltage (501, 601) on the high-voltage transformer (201),
- determining an impedance based on the absolute values and the phase positions of the current (502, 602) and the voltage (501, 601), and
- ending (708) the outputting of the high-voltage AC current depending on the temporal profile of the at least one electrical variable, wherein the outputting of the high-voltage AC current is ended if the impedance is lower than a predefined impedance threshold value.

2. The method of claim 1,
wherein the high-voltage transformer (201) comprises an input side (210) and an output side (211) at which the high-voltage AC current is output for the test object (300),
wherein the temporal profile of the at least one electrical variable is determined by means of detection at the input side (210) of the high-voltage transformer (201), and
wherein the outputting of the high-voltage AC current is also ended depending on at least one property of the high-voltage transformer (201).

3. The method of claim 1 or claim 2, wherein the method also comprises:
- determining a phase angle (503, 603) between the current (502, 602) and the voltage (501, 601) at the high-voltage transformer (201) based on the phase positions of the current (502, 602) and the voltage (501, 601), wherein the outputting of the high-voltage AC current is ended if the phase angle (503, 603) is smaller than a predefined phase angle threshold value.

4. The method of one of the preceding claims, wherein the method also comprises:
- determining a loss factor based on the phase positions of the current (502, 602) and the voltage (501, 601), wherein the outputting of the high-voltage AC current is ended if the loss factor is greater than a predefined loss factor threshold value.

5. The method of one of the preceding claims, wherein the method also comprises:
- determining a temporal profile of a power output by the high-voltage transformer (201) based on temporal profiles of the absolute values and the phase positions of the current (502, 602) and the voltage (501, 601), wherein the outputting of the high-voltage AC current is ended if the output power changes by more than a predefined power change value within a predefined time period.

6. The method of one of the preceding claims, wherein the at least one electrical variable comprises an absolute value of a current (502, 602) at the high-voltage transformer (201).

7. The method of claim 6, wherein the outputting of the high-voltage AC current is ended if the absolute value of the current (502, 602) exceeds a predefined current threshold value.

8. The method of claim 6 or claim 7, wherein the outputting of the high-voltage AC current is ended if a temporal profile of the absolute value of the current (502, 602) changes by more than a predefined current change value within a predefined time period.

9. The method of one of the preceding claims, wherein the at least one electrical variable comprises an absolute value of a voltage (501, 601) on the high-voltage transformer (201).

10. The method of claim 9, wherein the outputting of the high-voltage AC current is ended if the absolute value of the voltage (501, 601) does not reach a predefined minimum voltage during the outputting of the high-voltage AC current for the test object (300).

11. The method of claim 9 or claim 10, wherein the outputting of the high-voltage AC current is ended if a temporal profile of the absolute value of the voltage (501, 601) changes by more than a predefined voltage change value within a predefined time period.

12. The method of one of the preceding claims, wherein the outputting (701) of the high-voltage AC current comprises an outputting of a high-voltage AC current with a voltage absolute value that is increased continuously or in stages.

13. A high-voltage generating device for a high-voltage test of a test object, comprising:
- a high-voltage transformer (201) for generating a high-voltage AC current,
- an output (202) for outputting the high-voltage AC current for the test object (300), and
- a control device (203) that is designed to protect a person (400) during the high-voltage test by:
- outputting (701) the high-voltage AC current for the test object (300),
- determining (702) a temporal profile of at least one electrical variable at the high-voltage transformer (201) while the high-voltage AC current is being output, wherein the at least one electrical variable comprises a phase position and an absolute value of a current (502, 602) on the high-voltage transformer (201) and a phase position and an absolute value of a voltage (501, 601) on the high-voltage transformer (201),
- determining an impedance based on the absolute values and the phase positions of the current (502, 602) and the voltage (501, 601), and
- ending (708) the outputting of the high-voltage AC current depending on the temporal profile of the at least one electrical variable wherein the outputting of the high-voltage AC current is ended if the impedance is lower than a predefined impedance threshold value.

14. The high-voltage generating device of claim 13, wherein the high-voltage generating device (200) is designed to execute the method (700) of one of claims 1-12.

15. The high-voltage generating device of claim 13 or claim 14, wherein the high-voltage device is in the form of a portable device.

## Revendications

1. Procédé pour une protection des personnes lors d'un essai de haute tension sur un objet d'essai, comprenant :
- délivrer (701) un courant alternatif haute tension pour l'objet d'essai (300) au moyen d'un dispositif de génération de haute tension (200) qui comprend un transformateur haute tension (201) pour générer le courant alternatif haute tension,
- déterminer (702) une évolution temporelle d'au moins une grandeur électrique sur le transformateur haute tension (201) lors de la délivrance du courant alternatif haute tension, ladite au moins une grandeur électrique comprenant une position de phase et une amplitude d'un courant (502, 602) sur le transformateur haute tension (201) et une position de phase et une amplitude d'une tension (501, 601) sur le transformateur haute tension (201),
- déterminer une impédance sur la base des amplitudes et des positions de phase du courant (502, 602) et de la tension (501, 601), et
- arrêter (708) la délivrance du courant alternatif haute tension en fonction de l'évolution temporelle de ladite au moins une grandeur électrique, la délivrance du courant alternatif haute tension étant arrêtée lorsque l'impédance est inférieure à une valeur seuil d'impédance prédéterminée.

2. Procédé selon la revendication 1,
dans lequel le transformateur haute tension (201) comprend un côté entrée (210) et un côté sortie (211) auquel le courant alternatif haute tension est délivré pour l'objet d'essai (300),
dans lequel l'évolution temporelle d'au moins une grandeur électrique est déterminée par détection sur le côté entrée (210) du transformateur haute tension (201), et
dans lequel la délivrance du courant alternatif haute tension est également arrêtée en fonction d'au moins une caractéristique du transformateur haute tension (201).

3. Procédé selon la revendication 1 ou la revendication 2, ledit procédé comprenant en outre :
- déterminer un angle de phase (503, 603) entre le courant (502, 602) et la tension (501, 601) sur le transformateur haute tension (201) sur la base des positions de phase du courant (502, 602) et de la tension (501, 601), la délivrance du courant alternatif haute tension s'arrêtant lorsque l'angle de phase (503, 603) est inférieur à une valeur seuil d'angle de phase prédéterminée.

4. Procédé selon l'une quelconque des revendications précédentes, ledit procédé comprenant en outre :
- déterminer un facteur de perte sur la base des positions de phase du courant (502, 602) et de la tension (501, 601), la délivrance du courant alternatif haute tension s'arrêtant lorsque le facteur de perte est supérieur à une valeur seuil de facteur de perte prédéterminée.

5. Procédé selon l'une quelconque des revendications précédentes, ledit procédé comprenant en outre :
- déterminer une évolution temporelle d'une puissance émise par le transformateur haute tension (201) sur la base des évolutions temporelles des amplitudes et des positions de phase du courant (502, 602) et de la tension (501, 601), la délivrance du courant alternatif haute tension s'arrêtant si la puissance émise varie de plus d'une valeur de variation de puissance prédéterminée dans une période de temps prédéterminée.

6. Procédé selon l'une quelconque des revendications précédentes, dans lequel ladite au moins une grandeur électrique comprend une amplitude de courant (502, 602) sur le transformateur haute tension (201).

7. Procédé selon la revendication 6, dans lequel la délivrance du courant alternatif haute tension est arrêtée lorsque l'amplitude de courant (502, 602) dépasse une valeur seuil de courant prédéterminée.

8. Procédé selon la revendication 6 ou la revendication 7, dans lequel la délivrance du courant alternatif haute tension est arrêtée si une évolution temporelle de l'amplitude de courant (502, 602) change de plus d'une valeur de variation de courant prédéterminée dans une période de temps prédéterminée.

9. Procédé selon l'une quelconque des revendications précédentes, dans lequel ladite au moins une grandeur électrique comprend une amplitude d'une tension (501, 601) sur le transformateur haute tension (201).

10. Procédé selon la revendication 9, dans lequel la délivrance du courant alternatif haute tension est arrêtée si, lors de la délivrance du courant alternatif haute tension pour l'objet d'essai (300), l'amplitude de la tension (501, 601) n'atteint pas une tension minimale prédéterminée.

11. Procédé selon la revendication 9 ou la revendication 10, dans lequel la délivrance du courant alternatif haute tension est arrêtée si une évolution temporelle de l'amplitude de la tension (501, 601) change de plus d'une valeur de variation de tension prédéterminée dans une période de temps prédéterminée.

12. Procédé selon l'une quelconque des revendications précédentes, dans lequel la délivrance (701) du courant alternatif haute tension comprend une délivrance d'un courant alternatif haute tension avec une amplitude de tension augmentée en continu ou par paliers.

13. Dispositif de génération de haute tension pour un essai de haute tension sur un objet d'essai, comprenant :
- un transformateur haute tension (201) pour générer un courant alternatif haute tension,
- une sortie (202) de délivrance du courant alternatif haute tension pour l'objet d'essai (300), et
- un dispositif de commande (203) qui est configuré pour protéger une personne (400) lors de l'essai de haute tension en :
- délivrant (701) le courant alternatif haute tension pour l'objet d'essai (300),
- déterminant (702) une évolution temporelle d'au moins une grandeur électrique sur le transformateur haute tension (201) lors de la délivrance du courant alternatif haute tension, ladite au moins une grandeur électrique comprenant une position de phase et une amplitude d'un courant (502, 602) sur le transformateur haute tension (201) et une position de phase et une amplitude d'une tension (501, 601) sur le transformateur haute tension (201),
- déterminant une impédance sur la base des amplitudes et des positions de phase du courant (502, 602) et de la tension (501, 601), et
- arrêtant (708) la délivrance du courant alternatif haute tension en fonction de l'évolution temporelle de ladite au moins une grandeur électrique, la délivrance du courant alternatif haute tension étant arrêtée lorsque l'impédance est inférieure à une valeur seuil d'impédance prédéterminée.

14. Dispositif de génération de haute tension selon la revendication 13, dans lequel le dispositif de génération de haute tension (200) est configuré pour mettre en œuvre le procédé (700) selon l'une quelconque des revendications 1 à 12.

15. Dispositif de génération de haute tension selon la revendication 13 ou la revendication 14, dans lequel le dispositif de haute tension est configuré comme un dispositif portable.
